Europäisches Patentamt

European Patent Office

Office européen des brevets

(11) Numéro de publication: **0 234 167**

**A1**

## (12) DEMANDE DE BREVET EUROPEEN

(21) Numéro de dépôt: 86420281.7

(22) Date de dépôt: 19.11.86

(51) Int. Cl.⁴: **G01R 31/34** , **H02K 13/00**

(30) Priorité: 20.11.85 FR 8517349

(43) Date de publication de la demande:
02.09.87 Bulletin 87/36

(84) Etats contractants désignés:
**DE FR GB IT**

(71) Demandeur: **Rege Nero, Didier**
**49 rue du Docteur Frappaz**
**F-69100 Villeurbanne(FR)**
Demandeur: **Lopez, Christian**
**4, rue Louis Braille**
**F-69100 Villeurbanne(FR)**

(72) Inventeur: **Rege Nero, Didier**
**49 rue du Docteur Frappaz**
**F-69100 Villeurbanne(FR)**
Inventeur: **Lopez, Christian**
**4, rue Louis Braille**
**F-69100 Villeurbanne(FR)**

(54) **Dispositif détecteur d'anomalies sur moteurs alimentés en courant continu.**

(57) Il est constitué par une sonde 1 qui reçoit sur un support en stéatite tous les dépôts résultant de l'usure des balais ou du collecteur ou des dépôts extérieurs au moteur eau, huile, copeaux. Il en résulte une variation de résistance ; celle-ci est transmise par câble blindé 2 à un amplificateur différentiel 3 permettant de régler le zéro suivi d'un détecteur de seuil (triger de Smith) 4 permettant de régler le taux d' "anomalies" lui-même suivi d'un circuit interface 5 rendant compatible l'information de défaut avec l'utilisation. Cette invention est parti-culièrement utile dans le cadre d'une maintenance prédictive en surveillant l'usure des balais ou les conditions d'hygrométrie et de pollution nuisible à l'ensemble moteur variateur.

EP 0 234 167 A1

FIG.1

## Dispositif pour détecter des anomalies au niveau du collecteur d'un moteur alimenté par du courant continu.

La présent invention concerne un dispositif détecteur d'anomalies sur moteurs alimentés en courant continu.

Dans le contexte d'une maintenance prédictive, il est important de connaître en cours de fonctionnement les pannes possibles au niveau du collecteur. Le dispositif selon l'invention permet de procéder à la mesure d'un changement d'état résistif résultant d'une usure ou de l'action d'un élément extérieur au moteur et de déclencher une alarme.

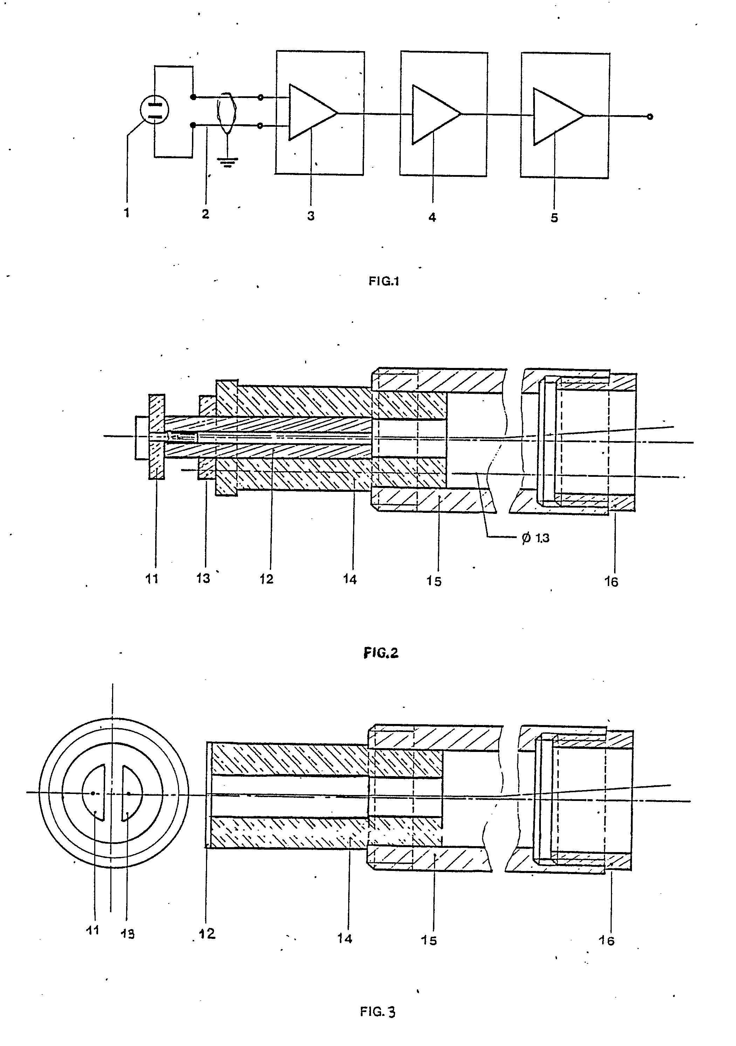

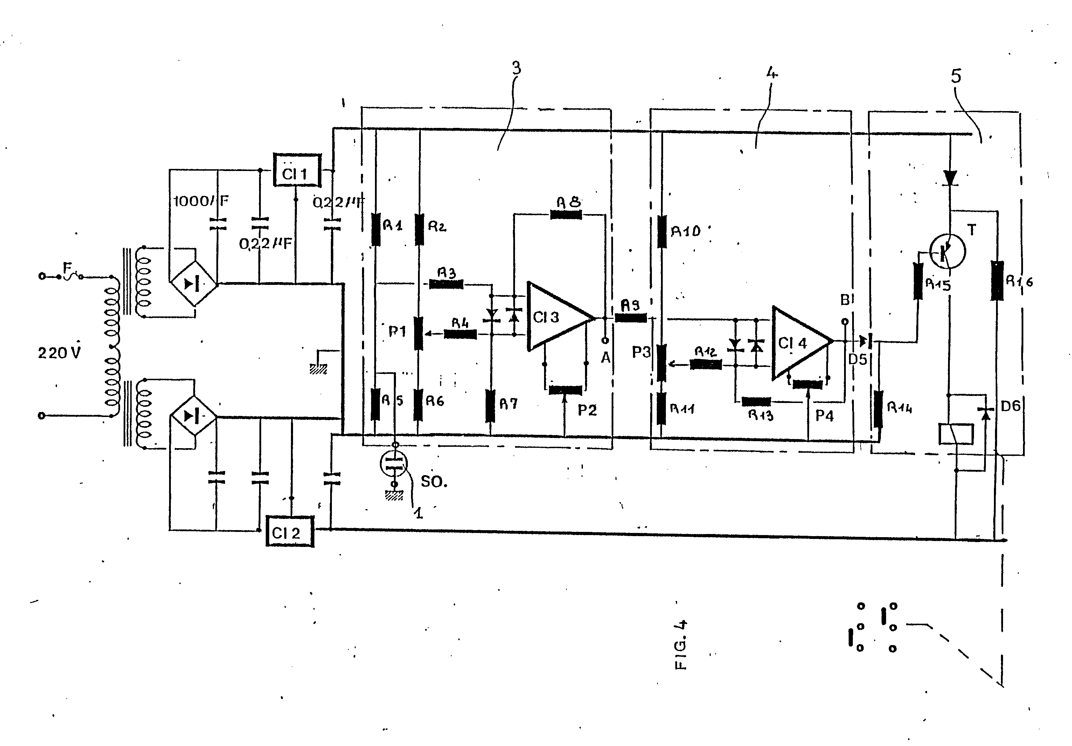

Il se présente sous la forme d'une sonde (fig. 2 et fig. 3). Les électrodes 11 et 13 en cuivre traité contre l'oxydation par un traitement approprié tel que étamage, dorure etc... assurent un contact avec un support isolant à haute tenue mécanique et thermique tel que la stéatite (fig. 2) ou le verre epoxy (fig. 3). Le corps de la sonde 14 est en matière isolante également, il est emboîté en collé à un embout métallique fileté 15 . Le pas du filetage pourra, pour simplifier le montage de la sonde, être normalisé suivant des normes électriques et assurer un maximum de garantie d'étanchéité. Un câble blindé est maintenu dans l'embout 15 par un écrou 16 et un enrobage étanche. Ce câble assure la liaison entre les électrodes et le circuit électronique.

Le circuit électronique comprend en entrée un amplificateur différentiel 3 suivi d'un dispositif à seuil de tension 4 (trigger de Schmitt) lui-même suivi d'un étage 5 servant d'interface avec l'utilisation.

Le support isolant 12 reçoit tout dépôt au niveau du collecteur. Ce dépôt peut être de plusieurs natures, soit en poussière de graphite issue de l'usure des balais plus ou moins agglomérée par de l'eau ou de l'huile, soit en débris métalliques de cuivre ou d'éléments de soudure du collecteur, soit en débris métalliques extérieurs au moteur tels que copeaux, soit de nature liquide telle que eau ou vapeur d'eau mélangée à l'huile de coupe.

Tous ou un de ces "dépôts" entraînent une variation de résistance entre les électrodes ; elle est infinie en l'absence de "dépôt". Les variations sont amplifiées par un amplificateur différentiel 3. Cette fonction est réalisée par un amplificateur opérationnel c13 dont la tension entre les entrées est limitée à 0,6 V par 2 diodes montées tête bêche. La valeur du potentiel de l'entrée positive est fixée par le réseau de résistances R2, R6, R4, R7. Le potentionmètre P1 permet le réglage de l'étage. OV au point A lorsque la sonde est propre. P2 sert à l'équilibrage de l'amplificateur opérationnel, c'est-à-dire OV en A -les 2 entrées réunies à la masse afin de parfaire le réglage. Le potentiel de l'entrée négative dépend de la résistivité de la sonde lié au réseau de résistance R1, R3, R5. La contre réaction produite par R8 fixe l'amplification en tension de l'étage.

Un détecteur de seuil 4 permet de régler le degré d'anomalie. Le but d'un tel montage est de transformer un signal à variation lente en un autre à fronts raides. Il utilise comme l'étage précédent un amplificateur opérationnel limité comme précédemment à 0,6 V entre les entrées, la tension résiduelle d'entrée étant annulée par P4. Le potentiomètre P3 associé à R10, R11, R12 fixe la tension de basculement et par là le degré d'anomalie. R13 assure la réaction sortie-entrée. L'information est disponible au point B.

Un étage final 5 sert d'interface avec l'utilisation que l'on désire faire de l'information : signalisation lumineuse, arrêt machine, liaison informatique etc... Dans l'exemple pris, il est utilisé un relais électromécanique commandé par un transistor T lui-même polarisé par R14, R15, R16.

Cette information prévient le service maintenance d'une anomalie pouvant entraîner à plus ou moins brève échéance la mise en panne du moteur et souvent du variaeur. Les pannes peuvent être diverses. Un défaut d'isolement ou amorce de celui-ci, il faut vérifier l'étanchéité du moteur. Une usure de balais, si elle est normale, il faut changer ceux-ci, si elle est excessive, il faut vérifier le collecteur. Une usure du collecteur due à des amorçages entre lames, il faut "toiler" celui-ci et vérifier ou régler le variateur.

Le dispositif redevient actif immédiatement après l'intervention et le nettoyage de la sonde.

La sonde est fixée au voisinage du collecteur. Le câble blindé est muni d'un connecteur débrochable permettant de relier la sonde à l'électronique quel que soit l'éloignement de l'une et l'autre partie. La présentation du coffret contenant l'électronique peut varier. Elle peut être sous la forme d'un coffret unitaire contenant son alimentation et un ensemble permettant de surveiller un moteur -cas de l'exemple fig. 4. Elle peut être également, suivant le type d'installation à surveiller, sous la forme d'un rack comprenant une alimentation et diverses "voies" permettant de surveiller tous les moteurs de l'installation.

L'alimentation sera dans tous les cas, double, redressée, filtrée et stabilisée par circuit intégré C11 et C12 dans l'exemple fig. 4.

**Revendications**

1. Dispositif pour détecter des anomalies au niveau du collecteur d'un moteur électrique, caractériseé en ce qu'il comporte une sonde 1 suivie d'un système électronique déclenchant une alarme par la variation de la résistance de ladite sonde due à un dépôt sur ladite sonde.

2. Dispositif selon la revendication 1 caractérisé selon que le support dépôt est en matière isolante à haute tenue mécanique et thermique telle que la stéatite ou le verre epoxy.

3. Dispositif selon la revendication 1 caractérisé selon que les électrodes assurant les contacts avec le support isolant sont en cuivre protégé contre l'oxydation par un traitement approprié tel que étamage, dorure etc...

4. Dispositif selon l'une quelconque des revendications précédentes caractérisé selon que tout "dépôt" polluant, qu'il soit normal -graphite dû à l'usure des balais-ou anormal -agent extérieur tel que eau, copeaux etc... entraînant une variation de résistance entre les électrodes. Cette résistance est infinie en absence de "dépôt".

5. Dispositif selon l'une quelconque des revendications précédentes caractérisé en ce que la liaison de la sonde 1 à l'électronique est en câble blindé, qu'elle pourra être munie d'un connecteur débrochable afin de pallier l'éloignement de l'une et l'autre partie.

6. Dispositif selon l'une quelconque des revendications précédentes caractérisé en ce que la sonde est fixée au voisinage du collecteur, qu'elle est munie pour cela d'un filetage permettant une garantie d'étanchéité de la fixation.

7. Dispositif selon l'une quelconque des revendications précédentes caractérisé par une partie électronique comportant un amplificateur différentiel 3 (fig. 1) suivi d'un détecteur de seuil -(trigger de Schmitt) 4 suivi d'un circuit interface 5 pour rendre l'information d'alarme compatible avec l'utilisation.

8. Dispositif selon l'une quelconque des revendications précédentes caractérisé selon que l'alimentation du système pourra être unitaire par système ou commune à plusieurs systèmes permettant ainsi une disposition en rack des contrôles de tous les moteurs d'un ensemble.

FIG.1

FIG.2

FIG.3

0 234 167

FIG. 4

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Ci.4) |
|---|---|---|---|
| A | GB-A-1 195 562 (J.N. SMITH) * Page 1, lignes 23-63; page 5, revendication 1, lignes 89-104 * | 1 | G 01 R 31/34 H 02 K 13/00 |
| A | DE-B-1 144 385 (ALLMÄNNA SVENSKA ELEKTRISKA AB) * Colonne 4, revendications 1,4,6; figure 1 * | 1,2 | |

DOMAINES TECHNIQUES RECHERCHES (Int. Cl.4)

G 01 R
H 02 K
G 01 N

Le présent rapport de recherche a été établi pour toutes les revendications

| Lieu de la recherche | Date d'achèvement de la recherche | Examinateur |
|---|---|---|
| LA HAYE | 02-03-1987 | KUSCHBERT D.E. |